# EUROPEAN PATENT SPECIFICATION

(11) **EP 1 639 636 B1**
(45) Date of publication and mention of the grant of the patent: **27.03.2019**
(21) Application number: 03817698.8
(22) Date of filing: 15.12.2003
(51) Int. Cl.: H01L 29/66, H01L 21/8238, H01L 29/78

(54) **OPTIMIZATION OF MECHANICAL STRAIN IN CHANNELS OF P-MOS AND N-MOS TRANSISTORS**
OPTIMIERUNG DER MECHANISCHEN VERSPANNUNG IN KANÄLEN VON P-MOS UND N-MOS TRANSISTOREN
OPTIMISATION DE LA TENSION MÉCANIQUE DANS LES CANAUX DE TRANSISTORS P-MOS ET N-MOS

(30) Priority: 27.06.2003 US 608870
(43) Date of publication of application: 29.03.2006
(60) Divisional application: 18176416.8
(73) Proprietor: Intel Corporation, Santa Clara, CA 95054 (US)
(72) Inventor: BOHR, Mark, Aloha, OR 97007 (US); GHANI, Tahir, Portland, OR 97229 (US); CEA, Stephen, Hillsboro, OR 97124 (US); MISTRY, Kaizad, Lake Oswego, OR 97035 (US); AUTH, Christopher, Portland, OR 97229 (US); ARMSTRONG, Mark, Portland, OR 97223 (US); ZAWADZKI, Keith, c/o Intel Corporation, Santa Clara, CA 95052-8119 (US)
(74) Representative: Goddar, Heinz J.
(86) International application number: PCT/US2003/039913
(87) International publication number: WO 2005/010982

(56) References cited:
- EP-A- 1 231 643
- EP-A2- 1 231 643
- US-A- 6 165 826
- US-A- 6 165 826
- US-A1- 2003 080 361
- US-B1- 6 214 679
- US-B1- 6 492 216
- PATENT ABSTRACTS OF JAPAN vol. 1999, no. 01, 29 January 1999 (1999-01-29) -& JP 10 270685 A (SONY CORP), 9 October 1998 (1998-10-09) -& US 6 682 965 B1 (SONEDA MITSUO ET AL) 27 January 2004 (2004-01-27)

## Description

### FIELD

Circuit devices and the manufacture and structure of circuit devices.

### BACKGROUND

Increased performance of circuit devices on a substrate (*e.g*., integrated circuit (IC) transistors, resistors, capacitors, etc. on a semiconductor (*e.g*., silicon) substrate) is usually a major factor considered during design, manufacture, and operation of those devices. For example, during design and manufacture or forming of, metal oxide semiconductor (MOS) transistor semiconductor devices, such as those used in a complementary metal oxide semiconductor (CMOS), it is often desired to increase movement of electrons in N-type MOS device (NMOS) channels and to increase movement of positive charged holes in P-type MOS device (PMOS) channels.

US 6 165 826 A discloses a transistor. Semiconductor material is formed both above and below a surface of a semiconductor substrate.

EP 1 231 643 A discloses a transistor that includes only a single device.

US 2003/080361 A1 discloses a PMOS semiconductor transistor comprising an alloy with a lattice larger than the lattice of a substrate material.

### BRIEF DESCRIPTION OP THE DRAWINGS

Various features, aspects, and advantages will become more thoroughly apparent from the following detailed description, appended claims, and accompanying drawings in which:
**Figure 1** is a schematic cross-section view of a portion of a semiconductor substrate after forming a well, gate dielectric, and gate electrode of NMOS and PMOS devices.
**Figure 2** shows the semiconductor substrate of Figure 1 after forming sidewall spacers and junction regions of the NMOS and PMOS devices.
**Figure 3** shows the semiconductor substrate of Figure 1 after forming of PMOS junction region voids.
**Figure 4** shows the semiconductor substrate of Figure 1 after depositing of silicon alloy material into the PMOS junction region voids.
**Figure 5** shows the substrate of **Figure 1** after forming of silicide layers on the diffusion regions and gate electrodes of the NMOS and PMOS devices.
**Figure 6** shows the substrate of **Figure 1** after the forming of a conformal etch stop layer over the NMOS and PMOS devices.
**Figure 7** shows the substrate of **Figure 1** after removing an etch stop layer from the PMOS device.
**Figure 8** is a flow diagram of a process for forming a CMOS structure having a PMOS device with silicon alloy material deposited in the junction regions such that the silicon alloy material is in a non-planar relationship with the surface of the substrate.

### DETAILED DESCRIPTION

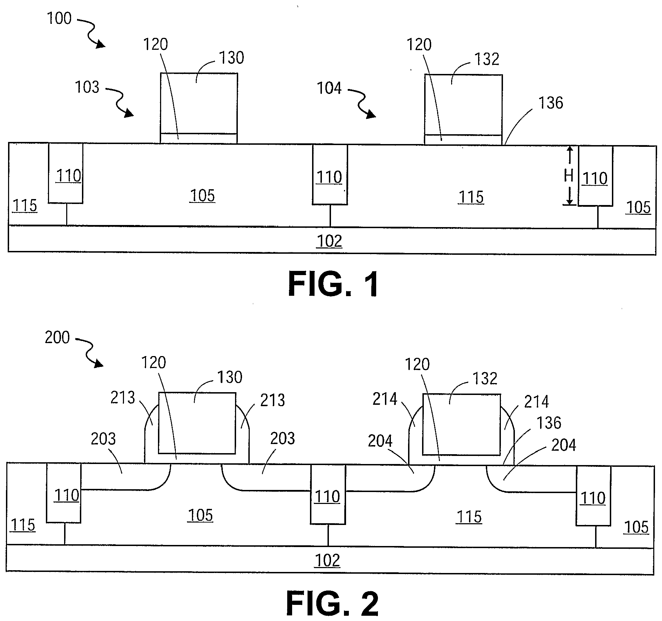

**Figure 1** is a schematic cross-section view of a portion of a semiconductor substrate after forming a well, gate dielectric, and gate electrode of an NMOS device and a PMOS device. Apparatus 100 *(e.g.,* such as one or more CMOS structures) includes semiconductor substrate 102, such as a silicon substrate, or epitaxial layer of a semiconductor substrate, having active areas or cell regions defined by isolation areas such as shallow trench isolation structures 110 formed in substrate or epitaxial layer 102. For example, substrate 102 may be formed or grown from single crystal silicon, and shallow trench isolation (STI) structures 110 may be formed by defining regions (through trench etching) and growing or depositing silicon dioxide (SiO₂) dielectric in the trench openings (*e.g*., such as formed to height H as shown in **Figure 1**). In embodiments, STI structures 110 define active areas or cell regions for individual transistor devices (*e.g*., such as NMOS and PMOS devices of a CMOS structure).

**Figure 1** also shows P-type well 105 and N-type well 115 formed in the individual active area or cell region defined by STI structures 110. For example, P-type well 105 is formed in one region of substrate 102 while N-type well 115 is formed in a second region of substrate 102. P-type well 105 is formed, such as, by introducing a dopant, such as boron (B) and/or aluminum (Al), into an area of substrate 102 designated for an N-type device. N-type well 115 is formed, such as, by introducing a dopant, such as arsenic (As), phosphorous (P), and/or antimony (Sb) in an area of substrate 102 designated for a P-type device. P-type well 105 and N-type well 115 may have work functions corresponding to the work function of an NMOS device and PMOS device, respectively, of a CMOS circuit. Practices for forming, sizes, and thicknesses (*e.g.*, depths) of STI structures 110 and wells 105 and 115 are known in the art and are, therefore, not presented further herein.

**Figure 1** shows substrate 102 after the forming a gate dielectric layer and gate electrode layer over the surface 136 of substrate 102, and subsequent patterning or removal of unwanted portions of the gate dielectric layer and/or gate electrode layer. For instance, as shown, gate dielectric 120 may be grown or deposited. An example of gate dielectric material that is typically grown by thermal techniques over substrate 102 is SiO₂. It is to be appreciated that, in addition to SiO₂, other gate dielectrics, such as carbon doped oxide (CDO), cubic boron nitride (CBN), phosphosilicate glass (PSG), silicon nitride (Si₃N₄), fluorinated silicate glass (FSG), silicon carbide (SiC) may be used to further optimize the CMOS transistor devices. For example, gate dielectric materials having a high dielectric constant may be used, if desired, for example, to increase the capacitance of the gate. Practices of forming, sizes, and thicknesses (*e.g*., heights) of gate dielectric 120 are known in the art, and are, therefore, not described further herein.

**Figure 1** shows a structure which includes gate electrodes 130 and 132 over the surface of substrate 102, such as by deposition onto gate dielectric 120. NMOS gate electrode 130 and PMOS gate electrode 132 may each be deposited to a thickness of, for example, 150-2000 angstroms (*e.g*., 15-200 nanometers (nm)). Accordingly, the thickness of NMOS gate electrode 130 and PMOS gate electrode 132 are each scalable and may be selected or chosen based on integration issues related to device performance. NMOS gate electrode 130 has a work function corresponding to the work function of an N-type device. PMOS gate electrode 132 has a work function corresponding to the work function of a P-type device. In embodiments, NMOS gate electrode 130 and PMOS gate electrode 132 are each silicon deposited by chemical vapor deposition (CVD) and then doped to form N-type and P-type materials, respectively, such as the doping is described above with respect to forming the N-type and P-type material of N-type well 115 and P-type well 105, respectively. For instance, NMOS gate electrode 130 may be doped at the same time that the corresponding NMOS junction regions are doped *(e.g.,* such as NMOS junction regions 203, shown in **Figure 2**), and PMOS gate electrode 132 may be doped at the same time the PMOS junction regions are doped (*e.g.,* such as PMOS junction regions 204, shown in **Figure 2**). Practices for forming, sizes (*e.g.,* area of gate dielectric 120 the gate electrodes cover) and additional thicknesses (*e.g*., heights) of NMOS gate electrode 130 and PMOS gate electrode 132 are known in the art, and are, therefore, not presented further herein.

**Figure 1** further shows the substrate after removal of undesired portions of gate dielectric 120 and NMOS gate electrode 130 and PMOS gate electrode 132, such as by patterning a mask layer over a defined area for NMOS gate electrode 130 and PMOS gate electrode 132 and etching away the undesired exposed portions not covered by the mask. For example, undesired portions of gate dielectric 120 and one or more types of gate electrode material may be patterned to form gate dielectric 120 and NMOS gate electrode 130 over NMOS device 103, and to form gate dielectric 120 and PMOS electrode 132 over PMOS device 104, such as by patterning using conventional techniques, such as plasma etchant, sputter etchant, and/or a chlorine-based etch chemistry. Masking and/or removal of gate dielectric and gate electrodes in the NMOS and PMOS devices may be performed simultaneously or in separate patterning, masking, and/or etching operations as are well known in the art, and are, therefore, not further described herein. For instance, according to embodiments, NMOS gate electrode 130 and PMOS gate electrode 132 are polysilicon deposited by CVD and then masked and etched.

**Figure 2** shows the semiconductor substrate of **Figure 1** after forming sidewall spacers and junction regions of the NMOS and PMOS devices. **Figure 2** shows NMOS gate isolation spacers 213 and PMOS gate isolation spacers 214 that may be formed, of a suitable dielectric incorporated around NMOS gate electrode 130 and PMOS gate electrode 132, respectively, to insolate the individual electrodes of the transistor devices. For example, NMOS gate isolation spacers 213 may be formed by depositing dielectric material, similar to dielectric materials described above for gate dielectric 120, along sidewalls of gate dielectric 120 and NMOS gate electrode 130 structure shown in **Figure 1** and then patterning and etching the formed or deposited dielectric material to create NMOS gate isolation spacers 213, such as patterning and etching techniques described above for NMOS and PMOS gate electrodes 120 and 130. Similarly, PMOS gate isolation spacers 214 may be formed of a suitable dielectric material incorporated around PMOS gate electrode 132 to insulate the individual electrodes of the transistor devices. For example, PMOS gate isolation spacers 214 may be formed of a similar material and using a similar method to that described above for forming NMOS gate isolation spacers 213. It is contemplated that NMOS gate isolation spacers 213 may be the same or a different material than PMOS gate isolation spacers 214. In an embodiment NMOS gate isolation spacers 213 and PMOS gate isolation spacers 214 are SiO₂. Moreover, processes for forming shapes, sizes, and thicknesses of gate isolation spacers such as NMOS gate isolation spacers 213 and PMOS gate isolation spacers 214 are known in the art *(e.g.,* and are sometimes referred to as "sidewall spacers" or "shoulder spacers"), and, therefore, are not further presented herein.

**Figure 2** shows NMOS junction regions 203 and PMOS junction regions 204 *(e.g.,* also referred to as "source-drain regions" or "diffusion regions") that may be formed by a junction implant (*e.g*., such as implanting with arsenic, phosphorous, and/or antimony for N-type junction regions 203 and boron and/or aluminum for P-type junction regions 204) and possibly include additionally corresponding type tip implants. Thus, NMOS junction regions 203 may be formed, such as by doping portions of P-type well 105 to form those junction regions. For example, NMOS junction regions 203 may be formed, in accordance with the characteristics of an NMOS device, such as by doping the material of P-type well 105, to form the N-type material in NMOS junction regions 203, as described above with respect to doping to form the N-type material of N-type well 115. Moreover, PMOS junction regions 204 may be formed, such as by doping portions of N-type well 115 to form those junction regions. For example, portions of N-type well 115 may be doped to form the P-type material in PMOS junction regions 204, in accordance with the characteristics of a PMOS device, such as by doping as described with respect to doping to form the P-type material of P-type well 105.

In addition, as noted above, according to embodiments, corresponding tip implants may be included in or incorporated with the junction regions. For example, NMOS junction regions 203 may also include additional N-type doping, such as implanting arsenic, phosphorous, and/or antimony into NMOS junction regions 203 adjacent to NMOS gate electrode 130 at an angle directed at the channel. Also, for example, PMOS junction regions 204 may also include additional P-type angled doping, such as implanting boron and/aluminum into PMOS junction regions 204 adjacent to PMOS gate electrode 132.

More specifically, embodiments include forming NMOS junction regions 203 by doping P-type well 105 with phosphorous, and further subsequently doping the region of P-type well 105 adjacent NMOS electrode 130 further with phosphorous to form tip implants. Also, embodiments include forming PMOS junction regions 205 by doping N-type well 115 with boron, and further subsequently doping portions of N-type well 115 adjacent to PMOS gate electrode 132 with boron to form P-type tip implants.

Portions of P-type well 105 may be doped with tip implants to form N-type material before or after formation of NMOS spacers 213, such as by doping as described above with respect to doping to form the N-type material of N-type well 115. Similarly, **Figure 2** shows PMOS tip implants 204 that may be formed, such as by doping portions of N-type well 115 to form those tip implants. For example, portions of N-type well 115 may be lightly doped to form P-type material before or after formation of PMOS spacers 214, such as by doping as described above with respect to doping to form the P-type material of P-type well 105. According to embodiments, formation of NMOS gate isolation spacers 213, PMOS gate isolation spacers 214, NMOS junction regions 203, and/or PMOS junction regions 204 may occur in any order as appropriate, such as in accordance with the characteristics of the desired device. Practices for forming, sizes, and thicknesses (*e.g*., depths) of NMOS junction regions 203 and PMOS junction regions 204, and possibly additionally including corresponding tip implants, are known in the art and are, therefore, not presented further herein.

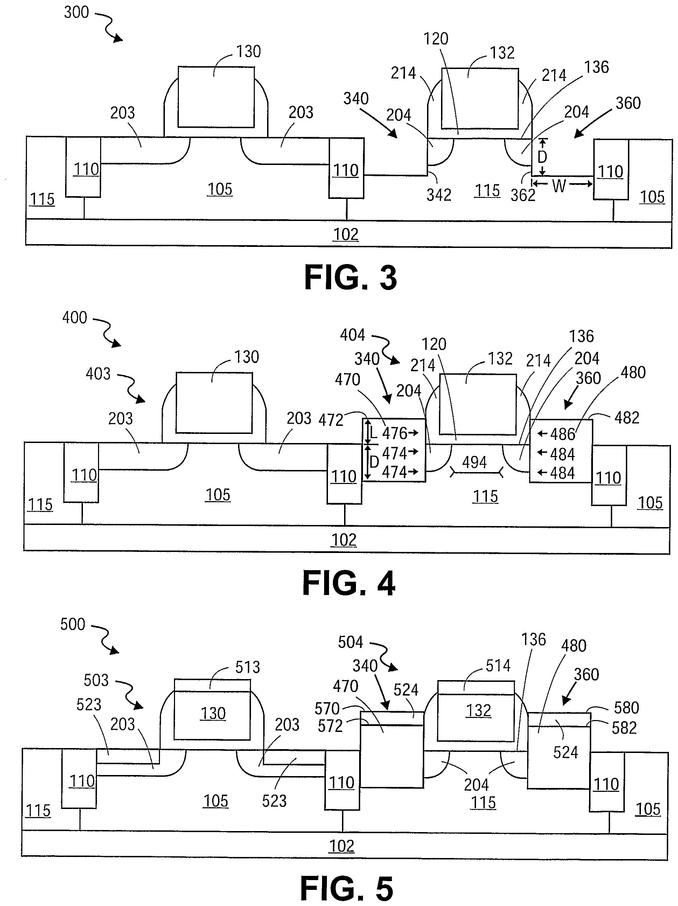

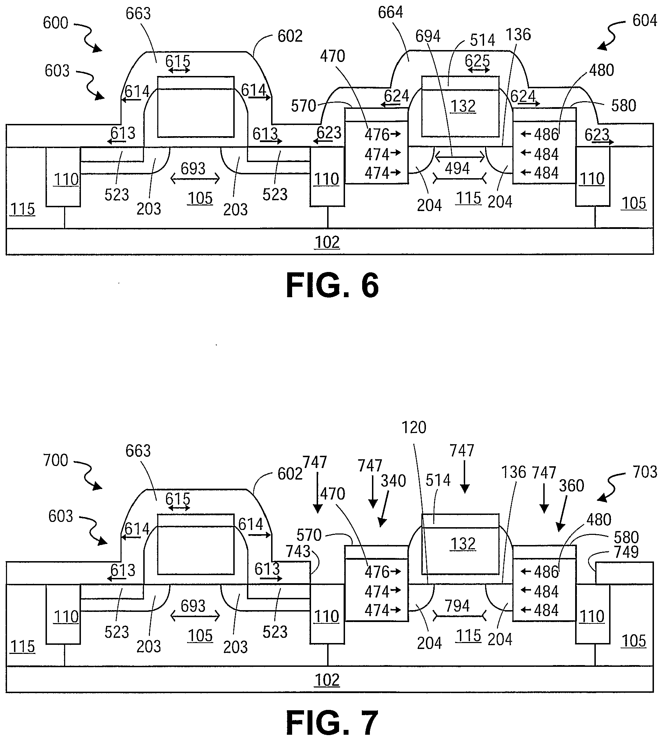

**Figure 3** shows the semiconductor substrate of **Figure 1** after the forming of PMOS junction region voids. **Figure 3** shows first PMOS junction region void 340 and second PMOS junction region void 360 that may be formed, by removing a portion of or all of PMOS junction regions 204, and/or portions of N-type well 115 *(e.g.,* such as portions of N-type well 115 adjacent to PMOS gate electrode 132). According to embodiments, first void 340 and second void 360 may be formed at various surface areas of surface 136 and to various dimensions *(e.g.,* such as to depth D, and width W, as shown in **Figure 3****,** and extending an extent E, not shown, but perpendicular to the cross-sectional view of **Figure 3**) in N-type well 115 within the space between STI 110 and an effective width of a channel under PMOS gate electrode 132 for the device. For example, in embodiments, first void 340 and second void 360 may be formed to a depth D in the range between 50 nanometers and 200 nanometers below surface 136, and to a width W in the range of between 90 nanometers and 270 nanometers. It is to be appreciated that, in embodiments, width W may be scaled according to the gate length, such as to be between one and three times the gate length. In addition, according to embodiments, first void 340 and second void 360 may be formed to a depth in the range of between 20 nanometers and 250 nanometers below surface 136, so that deposition of a silicon alloy in first void 340 and second void 360 to a height that is non-planar with surface 136 *(e.g.,* such as a height extending above surface 136) provides a PMOS device that operates sufficiently and in accordance with characteristics of the desired PMOS and/or CMOS structure (*e.g*., such as a desired PMOS as shown by the device on the right side of **Figure 6** or **7****,** or desired CMOS, such as shown by structures 600 or 700).

For example, first PMOS junction region void 340 and second PMOS junction region void 360 may be formed simultaneously or independently by patterning, etching, and/or recess etching (*e.g*., such as is described above for removing undesired portions of electrodes 130 and 132) to various desired sizes and depths characteristic for NMOS and PMOS devices by operations as are known in the art, and are therefore not described further herein. In addition, embodiments include wherein a surface of the substrate proximate to the first junction region (*e.g*., such as first PMOS junction region void 340) defines a first substrate sidewall surface 342, and a surface of the substrate proximate to the second junction region *(e.g.,* such as second PMOS junction region void 360) defines a second substrate sidewall surface 362.

**Figure 4** shows the semiconductor substrate of **Figure 1** after depositing of silicon alloy material into the PMOS junction region voids *(e.g.,* such as first PMOS junction region void 340 and second PMOS junction region void 360). **Figure 4** shows silicon alloy material 470 disposed in first PMOS junction region void 340 and silicon alloy material 480 disposed in second PMOS junction region void 360 such that surface 472 of the resulting first junction region is in a non-planar relationship with surface 136 of the substrate, and such that surface 482 of the resulting second junction region is also in a non-planar relationship with surface 136 of the substrate. Silicon alloy materials 470 and 480 may be formed of a suitable silicon alloy material disposed in first and second PMOS junction region voids 340 and 360, respectively, to cause strain 494 during performance of the device in a region of N-type well material 115 between silicon alloy material 470 and silicon alloy material 480 *(e.g.,* such as a strain in a region that may be referred to as the PMOS channel). Suitable silicon alloy materials that may be used to cause strain 494 include one or more of the following: silicon germanium (SiGe), silicon carbide (SiC), nickel silicide (NiSi), titanium silicide (TiSi₂), cobalt silicide (CoSi₂), and possibly may be doped with one or more of boron and/or aluminum. For example, silicon alloy material 470 and 480 may include a material having a silicon alloy lattice spacing that is different than the lattice spacing of the substrate material of N-type well 115. More specifically, in operation of the PMOS device, silicon alloy materials 470 and 480 may cause a compression in the well material or a compressive strain at strain 494 in a region of N-type well 115 caused by silicon alloy 470 and 480 having a lattice spacing that is a larger lattice spacing than the lattice spacing of N-type well 115 in that region.

Moreover, according to embodiments, silicon alloy materials 470 and 480 have a surface of the first junction region 472 and a surface of the second junction region 482 that are superior to the top surface (*e.g*., surface 136) of the substrate as viewed. The non-planar relationship between the junction regions and the substrate surface tends to cause first silicon alloy strain from point 474 below substrate surface, as well as first silicon alloy strain above substrate surface 476, and second silicon alloy strain below the substrate surface 484 and second silicon alloy strain above the substrate surface 486 which any and/or all of contribute to operation strain 494. For example, the thickness of silicon alloy material 470 and/or 480 deposited (*e.g*., the length L plus the depth D forming the height to surfaces 472 and/or 482) can be controlled by the time duration of the deposition and/or the deposition concentration, or deposition rate of the deposition operation. In addition, in embodiments, the silicon alloy material disposed or deposited in the first junction region (*e.g*., such as silicon alloy material 470) may be attached super adjacent to first substrate sidewall surface 342 and the silicon alloy material disposed or deposited in the second junction region (*e.g*., such as silicon alloy material 480) may be attached super adjacent to second substrate sidewall surface 362.

Thus, according to embodiments, first void 340 and second void 360 may be formed at suitable surface areas of surface 136 and to various dimensions and depths within N-type well 115 sufficient to provide desired operational strains 474, 476, 484, 486, and/or 494; including strains desired in accordance with characteristics of a desired PMOS device and/or CMOS structure (*e.g*., such as desired PMOS device, as shown by the device on the right side of **Figure 6** or **7****,** or desired CMOS structure, such as shown by structures 600 or 700). Hence, the dimensions and depth of first void 340 and second void 360, silicon alloy materials 470 and 480, and non-planar relationship of surfaces 472 and 482 with respect to surface 136 may be selected to cause a compressive strain at strain 494 in a range between 0.1 percent and 10 percent. Particularly, a proper design may be chosen to provide a compressive strain at strain 494 in the range between 0 percent and 2 percent or 0.5 percent and 2.5 percent *(e.g.,* for example, a compressive strain of approximately 1 percent). It is to be appreciated that, in embodiments, a sufficient compressive strain at strain 494 may be accomplished according to embodiments having a non planar relationship where length L is in a range between a fraction of an Angstrom and 200 nanometers.

According to embodiments, silicon alloy material 470 and/or 480 may be formed or deposited into first PMOS junction region void 340 and/or second PMOS junction region void 360, respectively, such by selective deposition, CVD deposition, or epitaxial deposition. For example, an epitaxial layer of single crystal semiconductor film may be formed upon a single crystal substrate, where the epitaxial layer has the same crystallographic characteristics as the substrate material, but differs in type or concentration of dopant. More particularly, silicon alloy materials 470 and/or 480 may be formed by selective CVD deposition, and possibly include epitaxial deposition of single crystal silicon alloy with the same crystal structure as that of the material of N-type well 115 *(e.g.,* having the same crystal structure meaning that if the material of N-type well 115 has a crystal grade of, for example, 100, 110, etc., then the silicon alloy deposited will have a similar or the same grade crystal grade, such as, 100, 110, etc.).

Furthermore, according to embodiments, silicon alloy materials 470 and/or 480 may be formed by epitaxial deposition of boron doped silicon germanium (SiGe), then annealing to remove the boron from the silicon germanium. Therefore, a layer of Si₁₋ₓGeₓ may be grown on top of a substrate of Si such that the silicon germanium has a bulk relaxed lattice constant that is larger *(e.g.,* such as by 4.2 percent) than the silicon it is grown on. The resulting misfit dislocation or dislocations at the block or blocks where the silicon germanium bonds to the silicon may create strains 474, 476, 484, 486, and/or 494. In other words, strain 494, such as a compressive strain, may result from the germanium atoms squeezed into the silicon of silicon alloy materials 470 and 480 such that those silicon alloys have a lattice spacing different and distorted as compared to the silicon material of N-type well 115.

Suitable processes for forming or growing of silicon alloy materials 470 and/or 480 include by vapor phase (VPE), liquid phase (LPE), or solid phase (SPE) blocks of silicon processing. For example, one such CVD process that is applicable to VPE of silicon includes: (1) transporting reactants to the substrate surface; (2) reactants absorbed on the substrate surface; (3) chemical reaction on the surface leading to formation of a film and reaction products; (4) reaction products deabsorbed from the surface; and (5) transportation away of the reaction product from the surface.

In addition, suitable forming of silicon alloy comprises selective epitaxial deposition, formation, or growth known in the art as Type 1 selective epitaxial deposition. Using Type 1 deposition, silicon alloy deposition would be occurring only on bare silicon substrates within the openings of the oxide film, and minimal, if any, growth on the oxide. Thus, in the embodiment shown in Figure 4, for example, silicon alloy material 470 and/or 480 are formed on surfaces of voids 340 and/or 360 respectively (*e.g.*, including PMOS junction regions 204), but are not formed on surfaces of STI 110, gate dielectric 120, PMOS gate isolation spacers 214, or PMOS gate electrode 132. Moreover, it is to be appreciated, that in embodiments, silicon alloy material (e.g,. such as material 470 and/or 480) may be formed on surfaces of voids 340 and/or 360, respectively, as well as on gate surfaces of STI 110, gate dielectric 120, PMOS gate isolation spacers 214 and/or PMOS gate electrode 132. Specifically, embodiments include silicon alloy material 470 and/or 480 formed by Type 1 selective epitaxial deposition using a silicon source including one or more of the following: silicon germanium (SiGe), silicon carbide (SiC), nickel silicide (NiSi), titanium silicide (TiSi₂), cobalt silicide (CoSi₂), halides, SiCl₄, SiHCl₃, SiHBr₃, and SiBr₄ at suitable temperatures. Also, SiH₂Cl₂, SiH4 may be used as a silicon source if hydrogen chloride (HCl), chlorine (Cl₂) is present.

Suitable selective epitaxial formation also includes Type 2 selective epitaxial deposition where selectivity of deposition is non-critical. Using Type 2 deposition, formation or growth of the silicon alloy occurs on bare silicon substrate, as well as on the oxide film, and thus when this type of deposition is made, an interface between the epitaxial layer of silicon alloy formed on the bare silicon substrate and a polysilicon layer of silicon alloy formed on the oxide film is created. The angle of this interface relative to the film growth direction depends on the crystallographic orientation of the substrate. Thus, in the embodiment shown in **Figure 4****,** for example, silicon alloy material 470 and/or 480 are formed on surfaces of voids 340 and/or 360, respectively (*e.g*., including PMOS junction regions 204), and may also be formed on surfaces of STI 110, gate dielectric 120, PMOS gate isolation spacers 214, and/or PMOS gate electrode 132. Particularly, embodiments include Type 2 selective epitaxial deposition using SiH₄, SiGe, SiC, NiSi, TiSi₂, and/or CoSi₂ as the silicon source.

Consequently, according to embodiments, subsequent to formation, undesired portions of silicon alloy material 470 and/or 480 may be patterned and/or etched away using various techniques known in the art *(e.g.,* such as is described above for removing undesired portions of electrodes 130 and 132) and, therefore, not presented herein.

Thus, according to embodiments, silicon alloy material 470 and/or 480 may be formed having surface of the first junction region 472 and/or surface of the second junction region 482 superior to a top surface of the substrate (*e.g*., such as surface 136) by a length in the range between 5 nanometers and 150 nanometers in length. For example, as shown in **Figure 4****,** surface of the first junction region 472 and/or surface of the second junction region 482 may extend superior to surface 136 of the substrate by length L between 400 and 500 angstroms (*e.g*., 40-50 nanometers), and silicon alloy materials 470 and/or 480 may extend into N-type well 115 to a depth D, as shown in **Figure 4****,** in a range of between 20 and 250 nanometers in depth. Moreover, contemplated are embodiments where depth D is approximately 120 nanometers and length L is in the range between 40 and 50 nanometers in length.

Furthermore, in embodiments, silicon alloy materials 470 and/or 480 may be deposited, as described above, and then doped to form junction regions in accordance with the characteristics of a desired PMOS device. For example, after deposition of silicon alloy materials 470 and/or 480, one or both of those materials may be doped such as by doping those materials, as described above with respect to doping to form the P-type material of P-type well 105. Thus, for example, silicon alloy materials 470 and/or 480 may be formed as, or may be doped to be, or to increase their polarity as electrically positively charged (P-type) junction region material. Consequently, it is contemplated that silicon alloy material 470 may be the same or different material, and may be doped the same or differently than silicon alloy material 480. Hence, according to embodiments, silicon alloy materials 470 and 480 may include silicon germanium formed by selective CVD deposition of an epitaxial layer having depth D of 120 nanometers and length L of 50 nanometers above surface 136 and subsequently doped with boron after deposition.

As a result, silicon alloy materials 470 and/or 480 may be selected to be materials of a type, doped suitably, in a junction region void of suitable dimensions, and/or extending to a length L above surface 136 sufficient to operate and/or provide desired strains 474, 476, 484, 486, and/or 494 in accordance with characteristics of a desired PMOS and/or CMOS structure *(e.g.,* such as desired PMOS, as shown by the device on the right side of **Figure 6** or **7****,** or desired CMOS, such as shown by structure 600 or 700).

In addition, according to embodiments, length L to surface of the first junction region 472 and/or a length to surface of the second junction region 482 may include a silicide layer and/or may be complemented by an additional length superior to surface 136 (as viewed) and including a layer of silicide material. For instance, **Figure 5** shows the substrate of **Figure 1** after forming silicide layers on the diffusion regions and gate electrodes of the NMOS and PMOS devices. NMOS junction silicide layers 523, NMOS gate silicide layer 513, PMOS junction region silicide layers 524, and PMOS gate silicide layer 514 formed in, on or in and on, NMOS junction regions 203, NMOS gate electrode 130, PMOS junction regions (*e.g*., such as portions or all of silicon alloy material 470 and 480, and non or some of PMOS junction regions 204) and PMOS gate electrode 132 respectively. Silicide layers 523, 513, 524, and/or 514 may be formed of the same or various suitable silicide materials and/or by the same or various suitable operations to provide an appropriate surface for coupling to an electrical contact formed to them in accordance with characteristics for the desired PMOS device and/or CMOS structure. For example, one or more of silicide layers 523, 513, 524, and 514 may be formed by sputtering down a blanket of suitable silicide material (*e.g.,* such as nickel (Ni), titanium (Ti), cobalt (Co), and annealing the silicide material so that it reacts with any exposed silicon to form the appropriate silicide layer *(e.g.,* such as nickel silicide (NiSi), titanium silicide (TiSi₂), and/or cobalt silicide (CoSi₂)). After sputtering down the blanket of suitable silicide material, undesired portions can be etched away (*e.g*., such as is described above for removing undesired portions of electrodes 130), such as by removal of any unreacted silicide material (*e.g*., such as any unreacted nickel, titanium, and/or cobalt).

According to embodiments, a layer of silicide material may be deposited along the entire exposed surface of structure 500 (*e.g*., such as NMOS device 503 and PMOS device 504 of a CMOS structure) and heated so that the silicide material partially diffuses into selected portions of that entire surface. Thus, it is contemplated that layer of silicide material 523, 513, 524, and/or 514 may consume a portion of NMOS junction regions 203, NMOS gate electrode 513, silicon alloy materials 570 and 580, and/or PMOS gate electrode 514, respectively. More particularly, layers of silicide material 523, 513, 524, and 514 may comprise nickel silicide consuming approximately 20 nanometers of silicon alloy materials 470 and 480 beginning at surfaces 472 and 482 and extending downward, as shown in **Figure 5****.** However, the formation of silicide layers 524 and 514 should be such that the formation of those silicide layers or subsequent operations do not cause silicide 524 and 514 to short together (*e.g*., such as by effecting the length L or surface height 570, 580, and/or height of silicide 514 to be effected such that silicides 524 short to silicide 514). Practices for forming, sizes, and thicknesses *(e.g.,* depth and height) of suitable silicide layers are well known in the art and are, therefore, not further described herein.

**Figure 6** shows the substrate of **Figure 1** after forming a conformal etch stop layer over the NMOS and PMOS devices. **Figure 6** shows NMOS conformal etch stop layer 663 covering exposed surfaces of NMOS device 603 and PMOS conformal etch stop layer 664 covering exposed surfaces of PMOS device 604. NMOS etch stop layer 663 and/or PMOS etch stop layer 664 may be formed by the same or various suitable operations known in the art and/or of the same or various suitable materials, such as by deposition, sputter deposition, and/or growth of silicon nitride (Si₃N₄) SiO₂, PSG, SiC, as well as various other appropriate materials, sizes, and thicknesses suitable for and in operations suitable for depositing those materials such that surfaces below NMOS etch stop layer 663 and/or PMOS etch stop layer 664 are protected (*e.g.*, such as silicide layers therebelow).

Further, according to embodiments, NMOS etch stop layer 663 and/or PMOS etch stop layer 664 may include a material that causes NMOS tension 693 in a region of P-type well material 105, as a result of tensile attributes of NMOS etch stop layer such as shown by NMOS etch stop layer tensile vectors 613, 614, and 615. Alternatively, an etch stop material may be selected, that causes PMOS tension 694 in a region of N-type well 115 such as a tension resulting from PMOS etch stop tensile vectors 623, 624, and 625. However, while the region of P-type well material may result in a channel that is overall in tension, as a result of the effect of tensile vectors 613, 614, and 615 of NMOS etch stop layer 663, the region of N-type well material 115 may experience a channel that overall is in compression of the tensile strain 694 that may be the result of vectors 623, 624, and 625 of PMOS etch stop layer 664 are counteracted by compressive strain 494 resulting from compressive vectors 474, 476, 484, and 486. Moreover, as first surface height 570 and second surface height 580 extend above surface 136, PMOS etch stop layer tensile vectors 623 and 624 have less of an effect and create a less powerful PMOS tension 694 than that of NMOS tension 693, because vectors 623 and 624 are pushed farther away from the region of N-type well material 115 *(e.g.,* the PMOS channel) by the formed or disposed silicon alloy materials 470 and 480 whose surfaces 570 and 580 extend above surface 136. Practices for forming, sizes, and thicknesses of etch stop layer 663 and/or 664 are known in the art and, are therefore not presented further herein.

**Figure 7** shows the substrate of **Figure 1** after removing an etch stop layer from the PMOS device. **Figure 7** shows an embodiment where PMOS etch stop layer 664 has been removed from one or more portions of the surfaces of PMOS device 703 *(e.g.,* such as is described above for removing undesired portions of electrodes 130 and 132). Thus, PMOS etch stop layer 664 may be removed, such as by patterned etching, selective etching, or other suitable removal techniques from PMOS surfaces 747 which may include the surfaces of one or more of STI 110, surface 170, surface 180, surfaces of gate isolation spacers for PMOS gate electrode 132, and/or the surface of PMOS gate electrode silicide 514. Moreover, removal of PMOS etch stop layer 664 may adjacent to a proximate end of STI 110, along the surface of STI 110 *(e.g.,* such as shown by edge 749), or adjacent to a distal end of STI 110 *(e.g.,* such as shown by edge 743). Practices of removing, area sizes removed, and thicknesses removed of etch stop layer 664 are known in the art and, are therefore not presented further herein.

According to embodiments, a sufficient or selected portion of area of, a thickness of the layer, and/or all of PMOS etch stop layer 664 is removed to decrease or eliminate any tension or tensile stress resulting from PMOS etch stop layer 664 where it has been removed. Thus, the residual strain 794 in N-type well 115 will include more of a compression in the channel as the strain associated with vectors 474, 476, 484, and 486 are kept largely in tact, while those of vectors 623, 624, and 625 have been substantially removed.

Furthermore, embodiments include formation of a dielectric layer *(e.g.,* such as a planarized interlayer dielectric (ILD) formed of SiO₂, PSG, Si₃N₄, and/or SiC, as well as various other appropriate materials for the CMOS structure desired) formed over any of the structures shown in **Figures 4-7****.** Practices for forming, sizes, and thicknesses of a dielectric layer formed over any of the structures shown in **Figures 4-7** is known in the art and is, therefore, not presented further herein.

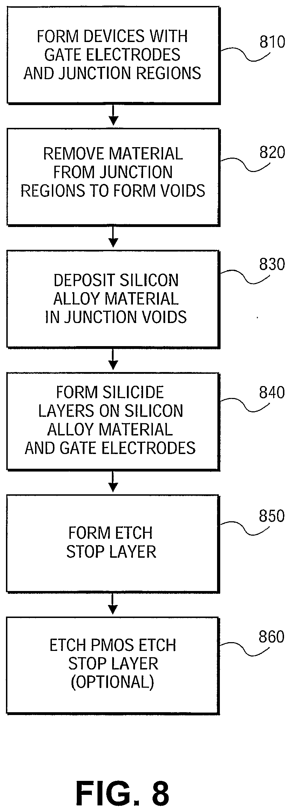

**Figure 8** is a flow diagram of a process for forming a CMOS structure having a PMOS device with silicon alloy material deposited in the junction regions such that the silicon alloy material is in a non-planar relationship with the surface of the substrate. At 810, NMOS and PMOS devices of a CMOS structure are formed on a substrate having the appropriate wells, junction regions, gate dielectrics, gate electrodes, and gate isolation spacers, and STIs *(e.g.,* such as is shown in **Figure 2**). At 820, a portion of PMOS junction regions 204 and possibly N-type well 115 are removed to a width and depth as desired adjacent PMOS gate electrode 132 *(e.g.,* such as is shown in **Figure 3**). For example, first and second PMOS junction region voids 340 and 360 may be formed such as by etching, as described herein.

At 830, silicon alloy material is deposited or formed in the PMOS junction regions such that a surface of the first junction region and a surface of the second junction region are in a non-planar relationship with the surface of the substrate (*e.g*., for example, as shown in **Figure 4**). For example, silicon germanium, doped silicon germanium, silicon carbide, silicon carbon, carbon doped silicon with lattice spacings different from than the silicon substrate *(e.g.,* N-type well 115) can be deposited including by an operation using one or more of CVD, epitaxial deposition, and/or selective deposition. Thus, for a PMOS device, such as shown by 404, a silicon alloy having a lattice spacing larger than that of the substrate can be deposited to provide a compressive strain in the substrate *(e.g.,* such as in the PMOS channel).

On the other hand, for an NMOS device, embodiments include formation of structure 404 where the electrical type of the materials is reversed *(e.g.,* such that well 115 is P-type material, gate electrode 132 is N-type material, etc. as necessary in accordance with the characteristics of the desired NMOS device). A silicon alloy material having a lattice spacing that is smaller than the silicon substrate *(e.g.,* such as silicon carbide, silicon carbine, and/or carbon doped silicon) can be deposited into a first and second NMOS junction region void *(e.g.,* the NMOS equivalence of voids 340 and 360) to cause a tensile or tension in the channel of the NMOS device (*e.g*., such as by creating the opposite vectors of those shown by 474, 476, 484, 486, and 494).

For example, a surface of the substrate may define a top surface of the substrate and the surface of the first junction region, and the surface of the second junction region *(e.g.,* of either a PMOS or NMOS device embodiment, as described above) are superior to the top surface of the substrate. Deposition of the silicon alloy material may include depositing a thickness or amount of the material sufficient to cause a desired strain *(e.g.,* a tension, or compression) in the substrate *(e.g.,* such as in a region of the well or channel of the device), as desired. Moreover, the deposition of silicon alloy material may include a concentration or type of silicon alloy material having a silicon alloy lattice spacing that comprises a different lattice spacing (*e.g*., smaller or larger) than the lattice spacing of the substrate material, as desired, to cause the target strain in the substrate. Furthermore, the deposition of the silicon alloy material may comprise deposition of one or more of silicon germanium, silicon carbide, doped with one or more of boron, and/or aluminum to form an electrically positive charge junction region material.

At 840, silicide layers are formed on the silicon alloy material and gate electrode (*e.g*., such as is shown in **Figure 5**). For example, nickel, titanium, and/or cobalt may be deposited onto the exposed surfaces, as shown in **Figure** 4, in a manner as known in the art such that the nickel, titanium, and/or cobalt reacts with any exposed silicon to form a silicide, and then any unreacted portions may be etched away. Thus, the silicide layers may consume of the silicon alloy material and/or gate electrode.

At 860, an etch stop layer may be formed over the current surfaces of the device *(e.g.,* such as is shown in **Figure 6**). For example, a conformal layer of tensile silicon nitride can be deposited on the NMOS and PMOS device sufficient to cause a compression in the NMOS channel. Moreover, the type, thickness, and/or method of deposition of the etch stop layer may be selected such that the resulting tension in the PMOS channel does not overcome the compression from the silicon alloy deposition selected.

Correspondingly, according to embodiments, a tensile etch stop layer may be selectively formed only over the NMOS portion of a CMOS structure. Alternately, according to embodiments, a tensile etch stop layer formed over a CMOS structure may be subsequently removed from the PMOS portion of the CMOS structure.

Although **Figures 1-8** describe formation of a CMOS structure having an NMOS device and PMOS device therein, embodiments include formation of a PMOS device portion, as described above (*e.g*., such as device 404, 504, 604, and/or 703) without the NMOS device. Thus, contemplated formation of independent single PMOS devices, single PMOS devices coupled to form a device other than a CMOS structure multiple coupled PMOS devices, or other appropriate circuit devices on a substrate where the description above with respect to silicon alloy material formed or disposed in junction regions such that the surface of the silicon alloy material is in a non-planar relationship with the surface of a substrate applies.

The invention is described with reference to specific embodiments thereof. It will, however, be evident that various modifications and changes may be made thereto within the scope of the invention as set forth in the claims. The specification and drawings are, accordingly, to be regarded in an illustrative rather than a restrictive sense.

## Claims

1. An apparatus comprising:
a substrate (102);
a PMOS device (115) on the substrate (102) including a gate electrode (132) on a surface (136) in an area of the substrate (102) defined by a first well;
a single crystal silicon alloy material disposed in each of a first junction region and a second junction region in the substrate adjacent the gate electrode (132) of the PMOS device (115), wherein (a) a lattice spacing of the silicon alloy material is different than a lattice spacing of a material of the first well of the substrate (102) and (b) a surface of the first junction region and a surface of the second junction region are in a non-planar relationship with the surface (136) of the substrate (102);
a NMOS device (105) complementary to the PMOS device (115) and comprising junction regions defined by doped portions of a material of a second well of the substrate (102), the material of the second well having a conductivity type different than a conductivity type of the first well; and
an etch stop layer conformally disposed on the substrate (102) on the NMOS device (105) exclusive of the PMOS device (115), wherein the etch stop layer covers exposed surfaces of the NMOS device (105) and causes tensile stress in the NMOS device (105).

2. The apparatus of claim 1, wherein a surface (136) of the substrate (102) defines a top surface of the substrate and the surface of the first junction region and the surface of the second junction region are superior to the top surface of the substrate (102).

3. The apparatus of claim 1, wherein the surface of the first junction region and the surface of the second junction region are superior to the top surface of the substrate (102) by a length in the range of between 5 nanometers and 150 nanometers.

4. The apparatus of claim 3, wherein the first junction region and the second junction region define a depth in the range of between 30 nanometers and 250 nanometers in depth.

5. The apparatus of claim 1, wherein the substrate is under a strain caused by the silicon alloy lattice spacing of the silicon alloy.

6. The apparatus of claim 1, wherein the substrate (102) is under a compressive strain caused by the silicon alloy lattice spacing being a larger lattice spacing than the lattice spacing of the substrate material.

7. The apparatus of claim 1, wherein a surface of the substrate (102) proximate to the first junction region defines a first substrate sidewall surface and a surface of the substrate (102) proximate to the second junction region defines a second substrate sidewall surface and the silicon alloy material disposed in the first junction region is attached to the first substrate sidewall surface and the silicon alloy material disposed in the second junction region is attached to the second substrate sidewall surface.

8. The apparatus of claim 1, wherein the silicon alloy material comprises an epitaxial layer of silicon alloy material.

9. The apparatus of claim 1, wherein the silicon alloy material comprises one of silicon germanium (Si_{y}-x Geₓ), silicon carbide (Si_{y}-x Cₓ), nickel silicide (NiSi), titanium silicide (TiSi₂), and cobalt silicide (CoSi₂).

10. The apparatus of claim 1, further comprising a layer of silicide material on the surface of the first junction region, the surface of the second junction region, and the gate electrode (132), wherein the layer of silicide material comprises one of nickel silicide (NiSi), titanium silicide (TiSi₂), and cobalt silicide (CoSi₂).

11. The apparatus of claim 10, wherein the layer of etch stop material comprises one of silicon dioxide (SiO₂), phosphosilicate glass (PSG, a Phosphorous doped SiO₂), silicon nitride (Si₃N₄), and silicon carbide (SiC).

12. The apparatus of claim 11, further comprising a layer of dielectric material on the surface of the substrate (102) below the gate electrode (132) of the PMOS device (115), wherein the layer of dielectric material comprises one of carbon doped oxide (CDO), cubic boron nitride (CBN), silicon dioxide (SiO₂), phosphosilicate glass (PSG), silicon nitride (Si₃N₄), fluorinated silicate glass (FSG), and silicon carbide (SiC).

13. The apparatus of claim 1, wherein the substrate (102) comprises an N-type channel /well material of one of silicon, polycrystalline silicon, and single crystal silicon having an electrically negative charge, and wherein the silicon alloy material comprises a P-type junction region material having an electrically positive charge.

14. A method comprising: forming a PMOS device (115) in an N-type well of a substrate (102) and a NMOS device (105) in a P-type well of the substrate (102), each device including:
a gate electrode (130, 132) on a surface (136) of the substrate (102);
a first junction region and a second junction region in the substrate adjacent the gate electrode;
depositing a silicon alloy material in each of the first junction region and the second junction region of the PMOS device (115) such that a surface of the first junction region and a surface of the second junction region are in a non-planar relationship with the surface (136) of the substrate (102) and wherein the lattice spacing of the silicon alloy material is different than the lattice spacing of the N-type well of the substrate (102); and
depositing an etch stop layer on the substrate (102) on the NMOS device (105) exclusive of the PMOS device (115), wherein the etch stop layer covers exposed surfaces of the NMOS device (105) and causes tensile stress in the NMOS device (105).

15. The method of claim 14, wherein depositing the silicon alloy material comprises a chemical vapor deposition sufficient to form an epitaxial layer of silicon alloy material.

16. The method of claim 14, wherein depositing the silicon alloy material comprises depositing silicon alloy material in the first junction region superjacent to a first substrate sidewall surface of the substrate proximate to the first junction region, and depositing silicon alloy material in the second junction region superjacent to a second substrate sidewall surface of the substrate proximate to the second junction region.

17. The method of claim 14, further comprising doping the substrate material with one of phosphorous, arsenic, and antimony to form the N-type well having an electrically negative charge.

18. The method of claim 14, further comprising doping the silicon alloy material with one of boron and aluminum to form a P-type junction region material having an electrically positive charge.

19. The method of claim 14, further comprising forming a layer of silicide material on the surface of the first junction region, the surface of the second junction region, and the gate electrode (130, 132) of each device.

## Patentansprüche

1. Vorrichtung, umfassend:
ein Substrat (102);
eine PMOS-Vorrichtung (115) auf dem Substrat (102), umfassend eine Gate-Elektrode (132) auf einer Oberfläche (136) in einem Bereich des Substrats (102), der durch eine erste Wanne definiert wird;
ein einkristallines Siliciumlegierungsmaterial, das in jedem von einem ersten Übergangsbereich und einem zweiten Übergangsbereich in dem Substrat benachbart zu der Gate-Elektrode (132) der PMOS-Vorrichtung (115) angeordnet ist, wobei (a) der Gitterabstand des Siliciumlegierungsmaterials von dem Gitterabstand des Materials der ersten Wanne des Substrats (102) verschieden ist und (b) eine Oberfläche des ersten Übergangsbereichs und eine Oberfläche des zweiten Übergangsbereichs in einer nichtplanaren Beziehung mit der Oberfläche (136) des Substrats (102) stehen;
eine NMOS-Vorrichtung (105), die zu der PMOS-Vorrichtung (115) komplementär ist und Übergangsbereiche umfasst, die durch dotierte Abschnitte des Materials einer zweiten Wanne des Substrats (102) definiert sind, wobei das Material der zweiten Wanne einen Leitfähigkeitstyp aufweist, der von dem Leitfähigkeitstyp der ersten Wanne verschieden ist; und
eine Ätzstoppschicht, die konform auf dem Substrat (102), auf der NMOD-Vorrichtung (105), aber nicht der PMOS-Vorrichtung (115) aufgebracht ist, wobei die Ätzstoppschicht freiliegende Oberflächen der NMOS-Vorrichtung (105) bedeckt und Zugspannung in der NMOS-Vorrichtung (105) verursacht.

2. Vorrichtung gemäß Anspruch 1, wobei eine Oberfläche (136) des Substrats (102) eine obere Oberfläche des Substrats definiert und die Oberfläche des ersten Übergangsbereichs und die Oberfläche des zweiten Übergangsbereichs über der oberen Oberfläche des Substrats (102) liegen.

3. Vorrichtung gemäß Anspruch 1, wobei die Oberfläche des ersten Übergangsbereichs und die Oberfläche des zweiten Übergangsbereichs um einen Abstand in dem Bereich zwischen 5 Nanometer und 150 Nanometer über der oberen Oberfläche des Substrats (102) liegen.

4. Vorrichtung gemäß Anspruch 3, wobei der erste Übergangsbereich und der zweite Übergangsbereich eine Tiefe in dem Bereich zwischen einer Tiefe von 30 Nanometer und 250 Nanometer definieren.

5. Vorrichtung gemäß Anspruch 1, wobei das Substrat unter einer Spannung steht, die durch den Siliciumlegierungs-Gitterabstand der Siliciumlegierung verursacht ist.

6. Vorrichtung gemäß Anspruch 1, wobei das Substrat (102) unter einer Kompressionsspannung steht, die dadurch verursacht ist, dass der Siliciumlegierungs-Gitterabstand ein größerer Gitterabstand als der Gitterabstand des Substratmaterials ist.

7. Vorrichtung gemäß Anspruch 1, wobei eine Oberfläche des Substrats (102) nahe dem ersten Übergangsbereich eine erste Substrat-Seitenwandoberfläche definiert und eine Oberfläche des Substrats (102) nahe dem zweiten Übergangsbereich eine zweite Substrat-Seitenwandoberfläche definiert und das Siliciumlegierungsmaterial, das in dem ersten Übergangsbereich angeordnet ist, an der ersten Substrat-Seitenwandoberfläche haftet und das Siliciumlegierungsmaterial, das in dem zweiten Übergangsbereich angeordnet ist, an der zweiten Substrat-Seitenwandoberfläche haftet.

8. Vorrichtung gemäß Anspruch 1, wobei das Siliciumlegierungsmaterial eine epitaktische Schicht von Siliciumlegierungsmaterial umfasst.

9. Vorrichtung gemäß Anspruch 1, wobei das Siliciumlegierungsmaterial eines von Silicium-Germanium (Si_{y}-xGeₓ), Siliciumcarbid (Si_{y}-xCₓ), Nickelsilicid (NiSi), Titansilicid (TiSi₂) und Cobaltsilicid (CoSi₂) umfasst.

10. Vorrichtung gemäß Anspruch 1, ferner umfassend eine Schicht von Silicidmaterial auf der Oberfläche des ersten Übergangsbereichs, der Oberfläche des zweiten Übergangsbereichs und der Gate-Elektrode (132), wobei die Schicht von Silicidmaterial eines von Nickelsilicid (NiSi), Titansilicid (TiSi₂) und Cobaltsilicid (CoSi₂) umfasst.

11. Vorrichtung gemäß Anspruch 10, wobei die Schicht von Ätzstoppmaterial eines von Siliciumdioxid (SiO₂), Phosphosilicatglas (PSG, ein phosphordotiertes SiO₂), Siliciumnitrid (Si₃N₄) und Siliciumcarbid (SiC) umfasst.

12. Vorrichtung gemäß Anspruch 11, ferner umfassend eine Schicht von dielektrischem Material auf der Oberfläche des Substrats (102) unter der Gate-Elektrode (132) der PMOS-Vorrichtung (115), wobei die Schicht von dielektrischem Material eines von kohlenstoffdotiertem Oxid (CDO), kubischem Bornitrid (CBN), Siliciumdioxid (SiO₂), Phosphosilicatglas (PSG), Siliciumnitrid (Si₃N₄), fluoriertem Silicatglas (FSG) und Siliciumcarbid (SiC) umfasst.

13. Vorrichtung gemäß Anspruch 1, wobei das Substrat (102) ein n-Typ-Kanal/Wannenmaterial aus einem von Silicium, polykristallinem Silicium und einkristallinem Silicium mit einer elektrisch negativen Ladung umfasst und wobei das Siliciumlegierungsmaterial ein p-Typ-Übergangsbereichmaterial mit einer elektrisch positiven Ladung umfasst.

14. Verfahren, umfassend:
Bilden einer PMOS-Vorrichtung (115) in einer n-Typ-Wanne eines Substrats (102) und einer NMOS-Vorrichtung (105) in einer p-Typ-Wanne des Substrats (102), wobei jede Vorrichtung umfasst:
eine Gate-Elektrode (130, 132) auf einer Oberfläche (136) des Substrats (102);
einen ersten Übergangsbereich und einen zweiten Übergangsbereich in dem Substrat benachbart zu der Gate-Elektrode;
Aufbringen eines Siliciumlegierungsmaterials in jedem von dem ersten Übergangsbereich und dem zweiten Übergangsbereich der PMOS-Vorrichtung (115), so dass eine Oberfläche des ersten Übergangsbereichs und eine Oberfläche des zweiten Übergangsbereichs in einer nichtplanaren Beziehung mit der Oberfläche (136) des Substrats (102) stehen, und wobei der Gitterabstand des Siliciumlegierungsmaterials von dem Gitterabstand der n-Typ-Wanne des Substrats (102) verschieden ist; und
Aufbringen einer Ätzstoppschicht auf das Substrat (102), auf die NMOS-Vorrichtung (105), aber nicht die PMOS-Vorrichtung (115), wobei die Ätzstoppschicht freiliegende Oberflächen der NMOS-Vorrichtung (105) bedeckt und Zugspannung in der NMOS-Vorrichtung (105) verursacht.

15. Verfahren gemäß Anspruch 14, wobei Aufbringen des Siliciumlegierungsmaterials eine chemische Dampfabscheidung umfasst, die ausreicht, um eine epitaktische Schicht von Siliciumlegierungsmaterial zu bilden.

16. Verfahren gemäß Anspruch 14, wobei Aufbringen des Siliciumlegierungsmaterials Aufbringen von Siliciumlegierungsmaterial in dem ersten Übergangsbereich über einer ersten Substrat-Seitenwandoberfläche des Substrats nahe dem ersten Übergangsbereich umfasst und Aufbringen von Siliciumlegierungsmaterial in dem zweiten Übergangsbereich über einer zweiten Substrat-Seitenwandoberfläche des Substrats nahe dem zweiten Übergangsbereich umfasst.

17. Verfahren gemäß Anspruch 14, ferner umfassend Dotieren des Substratmaterials mit einem von Phosphor, Arsen und Antimon, um die n-Typ-Wanne mit einer elektrisch negativen Ladung zu bilden.

18. Verfahren gemäß Anspruch 14, ferner umfassend Dotieren des Siliciumlegierungsmaterials mit einem von Bor und Aluminium, um ein p-Typ-Übergangsbereichsmaterial mit einer elektrisch positiven Ladung zu bilden.

19. Verfahren gemäß Anspruch 14, ferner umfassend Bilden einer Schicht von Silicidmaterial auf der Oberfläche des ersten Übergangsbereichs, der Oberfläche des zweiten Übergangsbereichs und der Gate-Elektrode (130, 132) jeder Vorrichtung.

## Revendications

1. Appareil comprenant :
un substrat (102) ;
un dispositif PMOS (115) sur le substrat (132) comportant une électrode de grille (132) sur une surface (136) dans une zone du substrat (102) définie par un premier puits ;
un matériau en alliage de silicium monocristallin disposé à la fois dans une première région de jonction et une deuxième région de jonction dans le substrat au voisinage de l'électrode de grille (132) du dispositif PMOS (115), dans lequel (a) un pas de réseau du matériau en alliage de silicium est différent d'un pas de réseau d'un matériau du premier puits du substrat (102) et (b) une surface de la première région de jonction et une surface de la deuxième région de jonction sont dans une relation non planaire avec la surface (136) du substrat (102) ;
un dispositif NMOS (105) complémentaire du dispositif PMOS (115) et comprenant des régions de jonction définies par des parties dopées d'un matériau d'un deuxième puits du substrat (102), le matériau du deuxième puits ayant un type de conductivité différent d'un type de conductivité du premier puits ; et
une couche d'arrêt de gravure disposée de façon enrobante sur le substrat (102) sur le dispositif NMOS (105) à l'exclusion du dispositif PMOS (115), la couche d'arrêt de gravure recouvrant des surfaces exposées du dispositif NMOS (105) et engendrant une contrainte de traction dans le dispositif NMOS (105).

2. Appareil de la revendication 1, dans lequel une surface (136) du substrat (102) définit une surface supérieure du substrat et la surface de la première région de jonction et la surface de la deuxième région de jonction sont plus hautes que la surface supérieure du substrat (102).

3. Appareil de la revendication 1, dans lequel la surface de la première région de jonction et la surface de la deuxième région de jonction sont plus hautes que la surface supérieure du substrat (102) d'une longueur dans la gamme entre 5 nanomètres et 150 nanomètres.

4. Appareil de la revendication 3, dans lequel la première région de jonction et la deuxième région de jonction définissent une profondeur dans la gamme entre 30 nanomètres et 250 nanomètres de profondeur.

5. Appareil de la revendication 1, dans lequel le substrat présente une déformation provoquée par le pas de réseau d'alliage de silicium de l'alliage de silicium.

6. Appareil de la revendication 1, dans lequel le substrat (102) présente une déformation compressive due au fait que le pas de réseau d'alliage de silicium est un pas de réseau plus grand que le pas de réseau du matériau substrat.

7. Appareil de la revendication 1, dans lequel une surface du substrat (102) à proximité de la première région de jonction définit une première surface de paroi latérale de substrat et une surface du substrat (102) à proximité de la deuxième région de jonction définit une deuxième surface de paroi latérale de substrat et le matériau en alliage de silicium disposé dans la première région de jonction est lié à la première surface de paroi latérale de substrat et le matériau en alliage de silicium disposé dans la deuxième de région de jonction est lié à la deuxième surface de paroi latérale de substrat.

8. Appareil de la revendication 1, dans lequel le matériau en alliage de silicium comprend une couche épitaxiale de matériau en alliage de silicium.

9. Appareil de la revendication 1, dans lequel le matériau en alliage de silicium comprend un composé parmi le silicium-germanium (Si_{y-x}Geₓ), le carbure de silicium (Si_{y-x}Cₓ), le siliciure de nickel (NiSi), le siliciure de titane (TiSi₂), et le siliciure de cobalt (CoSi₂).

10. Appareil de la revendication 1, comprenant en outre une couche de matériau en siliciure sur la surface de la première région de jonction, la surface de la deuxième région de jonction et l'électrode de grille (132), la couche de matériau en siliciure comprenant un composé parmi le siliciure de nickel (NiSi), le siliciure de titane (TiSi₂), et le siliciure de cobalt (CoSi₂).

11. Appareil de la revendication 10, dans lequel la couche de matériau d'arrêt de gravure comprend un composé parmi le dioxyde de silicium (SiO₂), le verre de phosphosilicate (PSG, un SiO₂ dopé au phosphore), le nitrure de silicium (Si₃N₄), et le carbure de silicium (SiC) .

12. Appareil de la revendication 11, comprenant en outre une couche de matériau diélectrique sur la surface du substrat (102) au-dessous de l'électrode de grille (132) du dispositif PMOS (115), la couche de matériau diélectrique comprenant un composé parmi un oxyde dopé au carbone (CDO), le nitrure de bore cubique (CBN), le dioxyde de silicium (SiO₂), le verre de phosphosilicate (PSG), le nitrure de silicium (Si₃N₄), le verre de fluorosilicate (FSG), et le carbure de silicium (SiC).

13. Appareil de la revendication 1, dans lequel le substrat (102) comprend un matériau de canal/puits de type N en silicium, ou silicium polycristallin, ou silicium monocristallin, ayant une charge électrique négative, et dans lequel le matériau en alliage de silicium comprend un matériau de région de jonction de type P ayant une charge électrique positive.

14. Procédé comprenant :
la formation d'un dispositif PMOS (115) dans un puits de type N d'un substrat (102) et d'un dispositif NMOS (105) dans un puits de type P du substrat (102), chaque dispositif comportant :
une électrode de grille (130, 132) sur une surface (136) du substrat (102) ;
une première région de jonction et une deuxième région de jonction dans le substrat au voisinage de l'électrode de grille ;
le dépôt d'un matériau en alliage de silicium à la fois dans la première région de jonction et la deuxième région de jonction du dispositif PMOS (115) de telle sorte qu'une surface de la première région de jonction et une surface de la deuxième région de jonction sont dans une relation non planaire avec la surface (136) du substrat (102), et dans lequel le pas de réseau du matériau en alliage de silicium est différent du pas de réseau du puits de type N du substrat (102) ; et
le dépôt d'une couche d'arrêt de gravure sur le substrat (102) sur le dispositif NMOS (105) à l'exclusion du dispositif PMOS (115), la couche d'arrêt de gravure recouvrant des surfaces exposées du dispositif NMOS (105) et engendrant une contrainte de traction dans le dispositif NMOS (105).

15. Procédé de la revendication 14, dans lequel le dépôt du matériau en alliage de silicium comprend un dépôt chimique en phase vapeur suffisant pour former une couche épitaxiale de matériau en alliage de silicium.

16. Procédé de la revendication 14, dans lequel le dépôt du matériau en alliage de silicium comprend le dépôt de matériau en alliage de silicium dans la première région de jonction au-dessus d'une première surface de paroi latérale de substrat du substrat à proximité de la première région de jonction, et le dépôt de matériau en alliage de silicium dans la deuxième région de jonction au-dessus d'une deuxième surface de paroi latérale de substrat du substrat à proximité de la deuxième région de jonction.

17. Procédé de la revendication 14, comprenant en outre le dopage du matériau substrat avec un élément parmi le phosphore, l'arsenic et l'antimoine pour former le puits de type N ayant une charge électrique négative.

18. Procédé de la revendication 14, comprenant en outre le dopage du matériau en alliage de silicium avec un élément parmi le bore et l'aluminium pour former un matériau de région de jonction de type P ayant une charge électrique positive.

19. Procédé de la revendication 14, comprenant en outre la formation d'une couche de matériau en siliciure sur la surface de la première région de jonction, la surface de la deuxième région de jonction et l'électrode de grille (130, 132) de chaque dispositif.
